# EUROPEAN PATENT APPLICATION

(11) **EP 4 123 788 A1**
(43) Date of publication of application: **25.01.2023**
(21) Application number: 21771830.3
(22) Date of filing: 20.01.2021
(51) Int. Cl.: H01M 10/48, H02J 7/00

(54) **INTERNAL RESISTANCE CALCULATION DEVICE, BATTERY CONTROL SYSTEM, AND INTERNAL RESISTANCE CALCULATION METHOD**

(30) Priority: 19.03.2020 JP 2020049105
(71) Applicant: KABUSHIKI KAISHA TOSHIBA, Minato-ku Tokyo 105-0023 (JP); Toshiba Infrastructure Systems & Solutions Corporation, Kawasaki-shi, Kanagawa 212-0013 (JP)
(72) Inventor: IDE, Makoto, Kawasaki-shi, Kanagawa 212-0013 (JP); KOYA, Takashi, Kawasaki-shi, Kanagawa 212-0013 (JP); YAMAMOTO, Masaaki, Kawasaki-shi, Kanagawa 212-0013 (JP)
(74) Representative: AWA Sweden AB
(86) International application number: PCT/JP2021/001912
(87) International publication number: WO 2021/186884

(57) **Abstract**

An internal resistance calculation device according to an embodiment includes a current acquisition unit, a voltage acquisition unit, a charge amount calculation unit, and an internal resistance calculation unit. The current acquisition unit acquires a battery current flowing through a battery. The voltage acquisition unit acquires a battery voltage applied to the battery. The charge amount calculation unit calculates an amount of charge that has moved to the battery. The amount of charge is calculated by integrating the battery current acquired by the current acquisition unit over time. The internal resistance calculation unit calculates internal resistance of the battery on the basis of an amount of variation in the battery current and an amount of variation in the battery voltage, each being obtained until the amount of charge calculated by the charge amount calculation unit becomes equal to or greater than a preset threshold.

## Description

### TECHNICAL FIELD

Embodiments of the present invention relate to an internal resistance calculation device, a battery control system, and an internal resistance calculation method.

### BACKGROUND ART

For a case of calculating internal resistance of a battery for diagnosing battery degradation and the like, a technique has been developed to perform measurement of a battery voltage on a no-load battery 10 seconds after the start of passing a square wave rated current (pulse current) with a four-level pulse current and to calculate, as internal resistance, the absolute value of the slope of an approximate line formed by the pulse current at each level and the battery voltage measured at each level. That is, the internal resistance of a battery is calculated on the basis of the amount of variation in current, which is an amount of variation in the pulse current flowing through the battery, and the amount of variation in voltage, which is an amount of variation in the battery voltage measured at each level.

### CITATION LIST

### Patent Literature

Patent Literature 1: Japanese Patent Application Laid-open No. 2000-121710
Patent Literature 2: Japanese Patent Application Laid-open No. 2010-249770

### SUMMARY OF THE INVENTION

### Problem to be Solved by the Invention

However, the above-described technique assumes testing using a DC power supply independently controllable for each battery, and the condition is that the current flowing through the battery is a pulse current. Therefore, if the current flowing through the battery is other than the pulse current, it is difficult to calculate the internal resistance of the battery with high precision.

### Means for Solving Problem

An internal resistance calculation device of an embodiment includes a current acquisition unit, a voltage acquisition unit, a charge amount calculation unit, and an internal resistance calculation unit. The current acquisition unit is configured to acquire a battery current flowing through a battery. The voltage acquisition unit is configured to acquire a battery voltage applied to the battery. The charge amount calculation unit configured to calculate an amount of charge that has moved to the battery. The amount of charge is calculated by integrating the battery current acquired by the current acquisition unit over time. The internal resistance calculation unit is configured to calculate internal resistance of the battery on the basis of an amount of variation in the battery current and an amount of variation in the battery voltage, each being obtained until the amount of charge calculated by the charge amount calculation unit becomes equal to or greater than a preset threshold.

### BRIEF DESCRIPTION OF DRAWINGS

FIG. 1 is a diagram illustrating an example of a configuration of a battery control system according to a first embodiment.
FIG. 2 is a block diagram illustrating an example of a functional configuration of a storage battery control device according to the first embodiment.
FIG. 3 is a diagram for describing an example of internal resistance calculation processing when an input current flowing through a battery system is a rated pulse current.
FIG. 4 is a diagram for describing an example of the internal resistance calculation processing when the input current flowing through the battery system is a ramp current.
FIG. 5 is a diagram for describing an example of the internal resistance calculation processing of a battery cell in the storage battery control device according to the first embodiment.
FIG. 6 is a diagram for describing an example of the internal resistance calculation processing of the battery cell in the storage battery control device according to the first embodiment.
FIG. 7 is a flowchart illustrating an example of the flow of the internal resistance calculation processing in the storage battery control device according to the first embodiment.
FIG. 8 is a block diagram illustrating an example of a functional configuration of a storage battery control device according to a second embodiment.

### DESCRIPTION OF EMBODIMENTS

An example of an internal resistance calculation device, a battery control system, and an internal resistance calculation method according to the present embodiment will be described below with reference to the accompanying drawings.

### (First Embodiment)

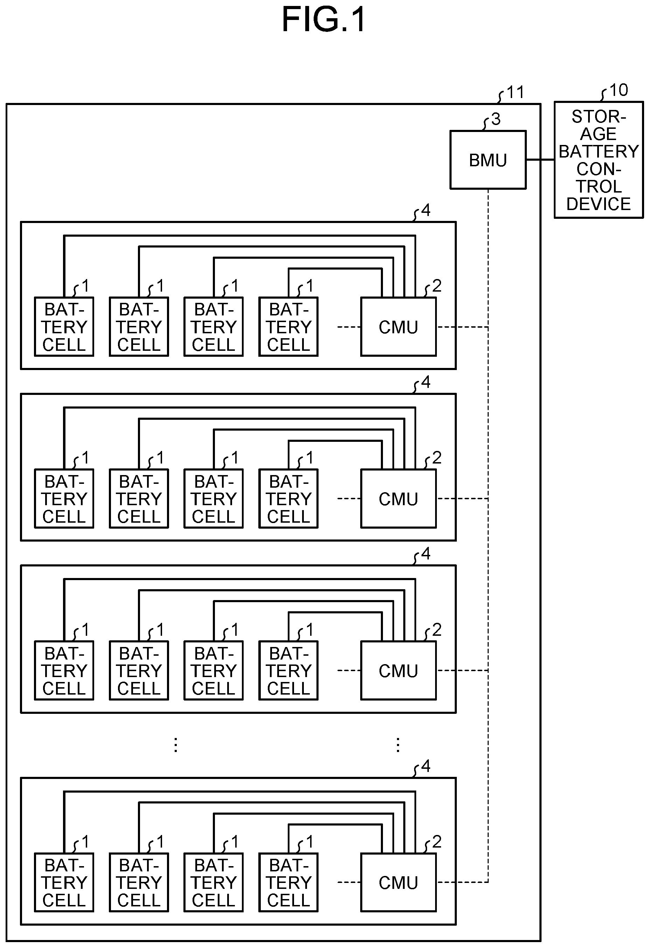

FIG. 1 is a diagram illustrating an example of a configuration of a battery control system according to a first embodiment. To begin with, an example of the configuration of the battery control system according to the present embodiment will be described with reference to FIG. 1.

The battery control system according to the present embodiment includes a battery system 11 and a storage battery control device 10, as illustrated in FIG. 1.

The battery system 11 includes a battery module 4 and a battery management unit (BMU) 3.

The battery module 4 includes battery cells 1 (each being an example of the battery) and a cell monitoring unit (CMU) 2. Each battery cell 1 is an electricity storage function unit that is capable of charging and discharging.

The CMU 2 is an example of a detection unit that detects a battery voltage applied to each of the battery cells 1 (hereinafter referred to as a terminal voltage), a battery temperature of the battery cell 1, and the like. The CMU 2 outputs the terminal voltage, the battery temperature, and the like of each of the battery cells 1 to the BMU 3.

The BMU3 monitors and protects the entire battery system 11. In the present embodiment, the BMU 3 monitors an input current flowing through the battery system 11, and a cell voltage and temperature of each battery module 4, and protects the battery system 11 when an abnormality is detected. In the present embodiment, the BMU 3 outputs various pieces of information such as the terminal voltage and battery temperature detected by the CMU 2, the input current flowing from an external power supply to the battery system 11, and the like to the storage battery control device 10.

Here, the input current flowing from the external power supply to the battery system 11 includes a current that reaches a rated current after an arbitrary time has elapsed since the current supply to the battery system 11 starts and is then maintained (or continues) as the rated current.

The storage battery control device 10 (an example of the internal resistance calculation device) is a device that controls the entire battery control system by using various pieces of information input from the BMU 3.

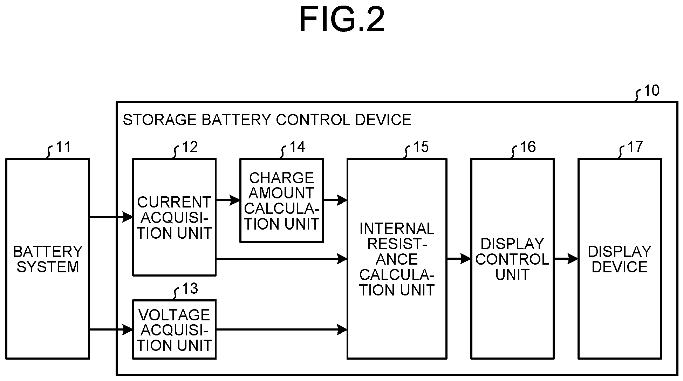

FIG. 2 is a block diagram illustrating an example of a functional configuration of the storage battery control device according to the first embodiment. Next, an example of the functional configuration of the storage battery control device 10 according to the present embodiment will be described with reference to FIG. 2.

In the present embodiment, the storage battery control device 10 includes, as illustrated in FIG. 2, a current acquisition unit 12, a voltage acquisition unit 13, a charge amount calculation unit 14, an internal resistance calculation unit 15, a display control unit 16, and a display device 17.

The current acquisition unit 12 acquires a cell current flowing through the battery cell 1 (an example of battery current). In the present embodiment, the current acquisition unit 12 calculates (or acquires), as the cell current flowing through the battery cell 1, a value obtained by dividing the input current output from the BMU 3 by the number of the battery modules 4 connected in parallel with each other.

The voltage acquisition unit 13 acquires the terminal voltage output from the BMU 3 (that is, terminal voltage applied to the battery cell 1).

The charge amount calculation unit 14 calculates an amount of charge having moved to the battery cell 1, by integrating the cell current acquired by the current acquisition unit 12 over time. Here, it is preferable to calculate the amount of charge at preset timing such as when starting from a no-load state or after performing a predetermined operation.

The internal resistance calculation unit 15 calculates internal resistance of the battery cell 1 on the basis of the amount of variation in the cell current and the amount of variation in the terminal voltage, each being obtained until the amount of charge calculated by the charge amount calculation unit 14 becomes equal to or greater than a predetermined threshold. With this configuration, even in a case where the input current flowing through the battery system 11 when calculating the internal resistance of the battery cell 1 is not a pulse current, the internal resistance of the battery cell 1 can be calculated with high precision by using, as an indicator, the amount of charge obtained by integrating over time the cell current flowing through the battery cell 1.

Note that the predetermined threshold is a threshold that is set in advance. In the present embodiment, the predetermined threshold is an amount of charge moving to the battery cell 1 when the rated pulse current flows through the battery cell 1 for a preset time (for example, 10 seconds) (that is, the predetermined threshold is an amount of charge calculated by integrating the rated pulse current over time when the rated pulse current flows through the battery cell 1 for the preset time).

The display control unit 16 generates degradation information indicating the degradation state of the battery cell 1 on the basis of the calculation result of the internal resistance of the battery cell 1 by the internal resistance calculation unit 15, and causes the display device 17 to display the generated degradation information. Note that the degradation information may be a scaling factor of the internal resistance of the battery cell 1 calculated by the internal resistance calculation unit 15 based on the internal resistance of the battery cell 1 that is not degraded. The degradation information is information indicating the degree of degradation of the battery cell 1 (for example, "blue" when the battery cell 1 is not degraded, "yellow" when the battery cell 1 is degraded but can be used, and "red" when the battery cell 1 is degraded and cannot be used).

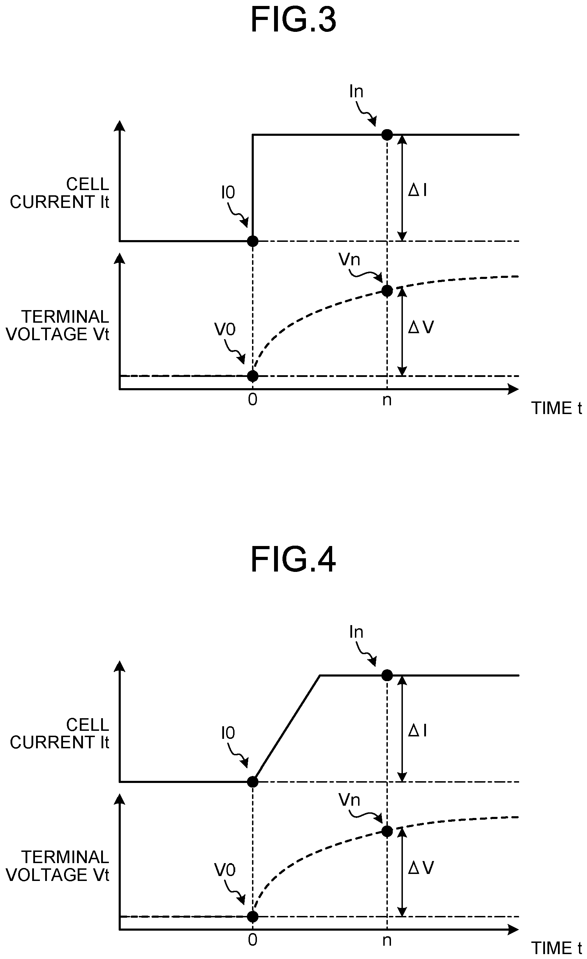

FIG. 3 is a diagram for describing an example of internal resistance calculation processing when the input current flowing through the battery system is a rated pulse current. FIG. 4 is a diagram for describing an example of the internal resistance calculation processing when the input current flowing through the battery system is a ramp current. In FIG. 3 and FIG. 4, the vertical axis represents the cell current It flowing through the battery cell 1 and the terminal voltage Vt, and the horizontal axis represents time t.

Next, with reference to FIG. 3 and FIG. 4, an example of the internal resistance calculation processing will be described in each of a case where the input current flowing through the battery system 11 is a rated pulse current and a case where the input current flowing through the battery system 11 is a ramp current.

As illustrated in FIG. 3, when precisely calculating the internal resistance R(Ω) of the battery cell 1, the terminal voltage Vt (= V0) and the cell current It (= 10) of the battery cell 1 in the no-load state, and the terminal voltage Vt (= Vn) and the cell current It (= In) of the battery cell 1 in a state where a preset time t (for example, 10 seconds) elapses since the input current that is a rated pulse current starts to flow through the battery system 11 from the no-load state are measured. Here, the no-load state of the battery cell 1 refers to a state where the cell current It is not flowing through the battery cell 1. The no-load state of the battery cell 1 is preferably a state where the terminal voltage Vt applied to the battery cell 1 and the temperature of the battery cell 1 are constant.

The ratio ΔV/ΔI of the amount of variation in voltage ΔV(= Vn - V0) being the amount of variation in the terminal voltage Vt to the amount of variation in current ΔI(= In - I0) being the amount of variation in the cell current It is calculated as the internal resistance R of the battery cell 1. According to the standard (JEVS D714), the internal resistance R calculated from the terminal voltage Vt and the cell current It when the pulse current flows through the battery cell 1 for 10 seconds is an indicator representing general battery performance and increases as the battery cell 1 degrades. Therefore, by following the secular change in the internal resistance R, it is possible to diagnose the degradation state of the battery cell 1.

However, this method of calculating the internal resistance R is premised on that the cell current It flows through the battery cell 1 by using a controllable DC power supply, so that the cell current It is on condition that it is a pulse current. Meanwhile, it is required to calculate the internal resistance R and diagnose the degradation state of the battery cell 1 with the battery cell 1 installed in the battery system 11. In this case, in the operation of the battery system 11, if there exists an operation of continuously passing a pulse current through the battery cell 1 in the no-load state for a preset time t, the internal resistance R can be calculated. However, depending on the operation and device constraints of the battery system 11, it may not be possible to pass a pulse current through the battery cell 1, and it may be difficult to calculate the internal resistance R accurately.

Specifically, as illustrated in FIG. 4, when the cell current It flowing through the battery cell 1 is a ramp current that reaches the rated current with a certain slope, the amount of charge flowing through the battery cell 1 decreases from when the cell current It starts to flow through the battery cell 1 in the no-load state until when a preset time t elapses. Therefore, when calculating the ratio ΔV/ΔI of the amount of variation in voltage ΔV (= Vn - V0) to the amount of variation in current ΔI (= In - I0) as the internal resistance R of the battery cell 1, an error is caused in the internal resistance R more than when the cell current It flowing through the battery cell 1 is a pulse current.

Considering the above, in the present embodiment, as described above, the internal resistance calculation unit 15 calculates the internal resistance R of the battery cell 1 on the basis of the amount of variation in the cell current It and the amount of variation in the terminal voltage Vt, each being obtained until the amount of charge calculated by integrating the cell current It flowing through the battery cell 1 over time becomes equal to or greater than a predetermined threshold.

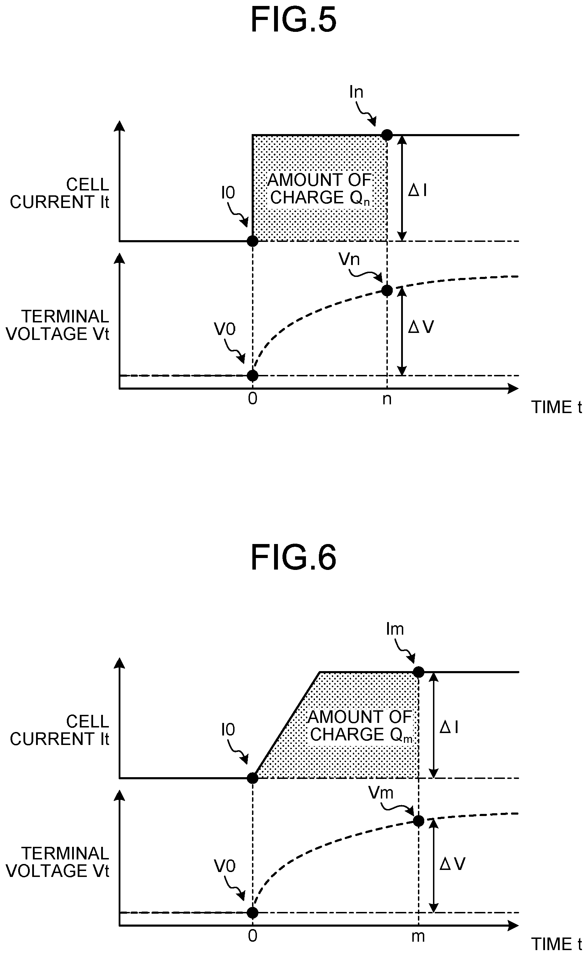

FIG. 5 and FIG. 6 are diagrams for describing an example of the internal resistance calculation processing of the battery cell in the storage battery control device according to the first embodiment. In FIG. 5 and FIG. 6, the vertical axis represents the cell current It flowing through the battery cell 1 and the terminal voltage Vt, and the horizontal axis represents time t.

Next, an example of the calculation processing of the internal resistance R in the storage battery control device 10 according to the present embodiment will be described with reference to FIG. 5 and FIG. 6.

As illustrated in FIG. 5, in a case where the cell current It flowing through the battery cell 1 is a rated pulse current, the internal resistance calculation unit 15 sets, to a predetermined threshold, the amount of charge Qn flowing into the battery cell 1, which is obtained from the time t (= 0) when the cell current It starts to flow through the battery cell 1 in the no-load state of the battery cell 1 until the time t (= n) when the preset time n elapses.

As illustrated in FIG. 6, in a case where the cell current It flowing through the battery cell 1 is a ramp current, the internal resistance calculation unit 15 calculates the internal resistance R of the battery cell 1 on the basis of the amount of variation in current ΔI and the amount of variation in voltage ΔV, each being obtained from the time t (= 0) when the cell current It starts to flow through the battery cell 1 in the no-load state of the battery cell 1 until the time t (= m) when the amount of charge Qm calculated by the charge amount calculation unit 14 reaches the amount of charge Qn (predetermined threshold Qn).

This makes it possible to calculate the internal resistance of the battery cell 1 on the basis of the amount of variation in current ΔI and the amount of variation in voltage ΔV in a case where the amount of charge flowing into the battery cell 1 when the rated pulse current is passed through the battery cell 1 for a preset time t (= n) is passed through the battery cell 1. As a result, even if the input current flowing through the battery system 11 for calculating the internal resistance of the battery cell 1 is not a pulse current, the internal resistance of the battery cell 1 can be calculated with high precision by using the amount of charge obtained by integrating the cell current flowing through the battery cell 1 over time as an indicator.

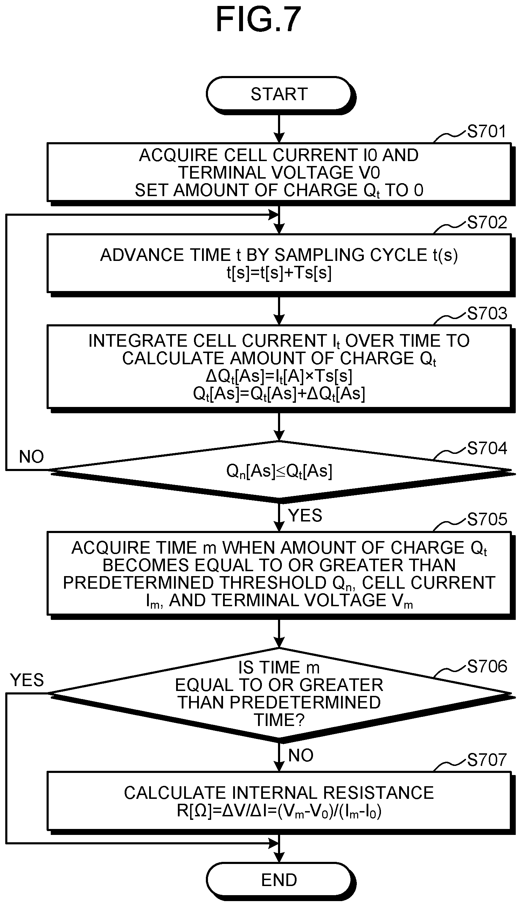

FIG. 7 is a flowchart illustrating an example of the flow of the internal resistance calculation processing in the storage battery control device according to the first embodiment. Next, an example of the flow of internal resistance calculation processing in the storage battery control device 10 according to the present embodiment will be described with reference to FIG. 7.

The current acquisition unit 12 acquires the cell current It (= 10) of the battery cell 1 at a given time t (= 0) such as a preset timing (Step S701). The voltage acquisition unit 13 acquires the terminal voltage Vt (= V0) of the battery cell 1 at time t (= 0) (Step S701). Moreover, the charge amount calculation unit 14 sets, to 0, the amount of charge Qt that has moved to the battery cell 1 (Step S701).

Next, the current acquisition unit 12 advances the time t by the sampling cycle Ts of the cell current It (for example, 0.12 seconds) and acquires the cell current It (Step S702). The voltage acquisition unit 13 also acquires the terminal voltage Vt by advancing the time t by the sampling cycle Ts (Step S702).

Every time the cell current It is acquired, the charge amount calculation unit 14 calculates the amount of variation in charge ΔQt by multiplying the acquired cell current It by the sampling cycle Ts. Then, the charge amount calculation unit 14 adds the calculated amount of variation in charge ΔQt to the amount of charge Qt to calculate a new amount of charge Qt obtained by integrating the cell current It over time (Step S703).

Every time the new amount of charge Qt is calculated, the internal resistance calculation unit 15 determines whether the amount of charge Qt becomes equal to or greater than the predetermined threshold Qn (Step S704). On determining that the amount of charge Qt is less than the predetermined threshold Qn (Step S704: No), the process returns to Step S702.

On the other hand, on determining that the amount of charge Qt becomes equal to or greater than the predetermined threshold Qn (Step S704: Yes), the internal resistance calculation unit 15 determines the time t (= m) when the amount of charge Qt becomes equal to or greater than the predetermined threshold Qn, and acquires the terminal voltage Vt (= Vm) and the cell current It (= Im) at the determined time m (Step S705).

Subsequently, the internal resistance calculation unit 15 determines whether the time m is equal to or greater than a predetermined time (Step S706). Here, the predetermined time is a time that is set in advance and is, for example, 60 seconds. Then, when the time m is equal to or greater than the predetermined time, the internal resistance calculation unit 15 does not calculate the internal resistance of the battery cell 1.

Specifically, if the elapsed time from when the cell current starts to be passed through the battery cell 1 until the amount of charge Qt becomes equal to or greater than the predetermined threshold is equal to or greater than the predetermined time, the internal resistance calculation unit 15 does not calculate the internal resistance of the battery cell 1. Alternatively, when the elapsed time from when the cell current starts to be passed through the battery cell 1 until the amount of charge Qt becomes equal to or greater than the predetermined threshold is equal to or greater than the predetermined time, the internal resistance calculation unit 15 discards the calculation result of the internal resistance of the battery cell 1. As a result, when it takes time for the amount of charge Qt flowing through the battery cell 1 to reach the predetermined threshold, and when the calculation precision of the internal resistance of the battery cell 1 becomes low because of the change in the temperature of the battery cell 1 or the like, the internal resistance of the battery cell 1 is not calculated, thereby improving the calculation precision of the internal resistance of the battery cell 1.

Meanwhile, when the time m is less than the predetermined time, by using the cell current I0 and the terminal voltage V0 of the battery cell 1 at the time t (= 0) and the cell current Im and the terminal voltage Vm of the battery cell 1 at the time m, the internal resistance calculation unit 15 calculates the ratio ΔV/ΔI of the amount of variation in voltage ΔV (= Vm - V0) to the amount of variation in current ΔI (= Im - I0) as the internal resistance R (Step S707).

Even if the input current flowing through the battery system 11 when calculating the internal resistance of the battery cell 1 is not a pulse current, the storage battery control device 10 according to the first embodiment is able to calculate the internal resistance of the battery cell 1 with high precision by using the amount of charge obtained by integrating over time the cell current flowing through the battery cell 1 as an indicator

In the present embodiment, the storage battery control device 10 acquires the cell current and the terminal voltage of the battery cell 1, and calculates the internal resistance of the single battery cell 1 by using the acquired cell current and the terminal voltage. It is also possible to calculate the internal resistance of each battery module 4 or battery unit by using the cell current and the terminal voltage of each battery module 4 or battery unit in which the battery cells 1 are connected in series or in parallel.

### (Second Embodiment)

The present embodiment is an example of acquiring a temperature of a battery cell and correcting a calculation result of internal resistance of the battery cell on the basis of the acquired temperature of the battery cell. In the following description, the description of a configuration similar to the configuration of the first embodiment will be omitted.

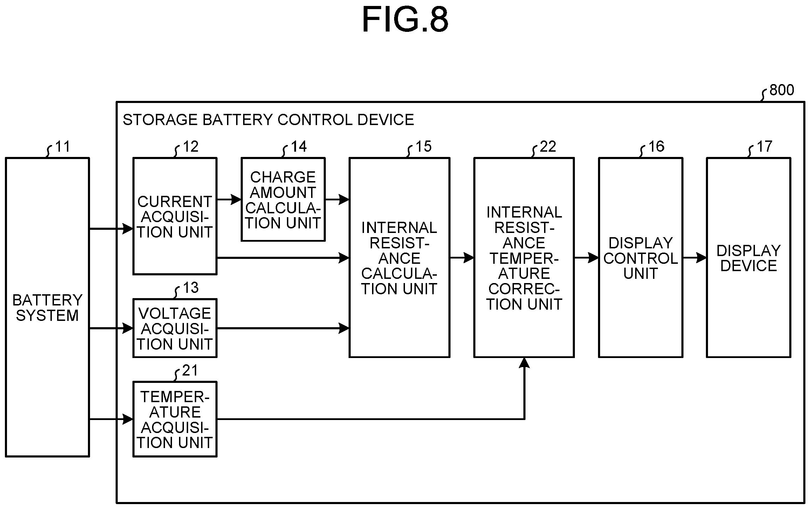

FIG. 8 is a block diagram illustrating an example of a functional configuration of a storage battery control device according to the second embodiment. In the present embodiment, a storage battery control device 800 includes a temperature acquisition unit 21 and an internal resistance temperature correction unit 22, in addition to a current acquisition unit 12, a voltage acquisition unit 13, a charge amount calculation unit 14, an internal resistance calculation unit 15, a display control unit 16, and a display device 17.

The temperature acquisition unit 21 acquires a battery temperature of a battery cell 1 output from a BMU 3.

The internal resistance temperature correction unit 22 is an example of a correction unit that corrects internal resistance of the battery cell 1 calculated by the internal resistance calculation unit 15 on the basis of the battery temperature of the battery cell 1 acquired by the temperature acquisition unit 21. Specifically, the internal resistance temperature correction unit 22 normalizes the calculation result of the internal resistance of the battery cell 1 at a preset battery temperature (for example, 25°C) on the basis of the battery temperature of the battery cell 1. This allows elimination of the influence of temperature properties of the internal resistance of the battery cell 1, thereby making it possible to follow the secular change in the internal resistance caused by degradation of the battery cell 1.

The battery cell 1 has a temperature property that the internal resistance is high when the battery temperature of the battery cell 1 is low, and the internal resistance is low when the battery temperature of the battery cell 1 is high. Therefore, when diagnosing the degradation state of the battery cell 1 by following the secular change in the internal resistance of the battery cell 1, if the internal resistance of the battery cell 1 can be calculated at the same battery temperature, the degradation state of the battery cell 1 can be diagnosed without considering the temperature properties of the battery cell 1.

However, for a battery with inconstant battery temperature due to the outside air temperature, ambient heat source, and the like, such as the battery cell 1 mounted on a vehicle, the battery temperature when detecting measured values such as a cell current used to calculate the internal resistance is different. Even if the secular change in the internal resistance of the battery is followed, it is difficult to determine whether the secular change in the internal resistance has increased because of degradation or the internal resistance has increased because of a decrease in the temperature of the battery.

Therefore, according to the present embodiment, as described above, the internal resistance temperature correction unit 22 corrects the internal resistance of the battery cell 1 calculated by the internal resistance calculation unit 15 on the basis of the battery temperature of the battery cell 1 acquired by the temperature acquisition unit 21. For example, the internal resistance temperature correction unit 22 determines the correction value of the internal resistance corresponding to the acquired battery temperature of the battery cell 1 with reference to a correction table. Here, the correction table is a table that associates the battery temperature of the battery cell 1 with the correction value of the internal resistance obtained by a property test or the like for the battery cell 1. Then, the internal resistance temperature correction unit 22 corrects the calculation result of the internal resistance by the internal resistance calculation unit 15 with reference to the determined correction value.

In this way, the storage battery control device 800 according to the second embodiment allows elimination of the influence of the temperature properties of the internal resistance of the battery cell 1, thereby making it possible to follow the secular change in the internal resistance caused by the degradation of the battery cell 1.

### (Third Embodiment)

The present embodiment is an example of integrating a cell current of a battery cell on the basis of a case where the battery cell is in a no-load state to calculate an amount of charge that has moved to the battery cell. In the following description, the description of a configuration similar to the configuration of the first and second embodiments will be omitted.

In the present embodiment, a charge amount calculation unit 14 integrates the cell current acquired by a current acquisition unit 12 over time to calculate an amount of charge that has moved to a battery cell 1 on the basis of a case where the battery cell 1 is in a no-load state. This makes it possible to suppress the influence of the cell current of the battery cell 1 before calculating internal resistance of the battery cell 1 on a terminal voltage of the battery cell 1, thereby improving calculation precision of the internal resistance of the battery cell 1.

Here, the no-load state of the battery cell 1 refers to a state where the cell current flowing through the battery cell 1 is 0 A. The no-load state of the battery cell 1 is preferably a state where the terminal voltage and battery temperature of the battery cell 1 are stable, in addition to the cell current flowing through the battery cell 1 being 0 A (for example, a state where the terminal voltage and the battery temperature of the battery cell 1 are preset terminal voltage and battery temperature).

In a case where the battery cell 1 is operated before the internal resistance of the battery cell 1 is calculated, the terminal voltage of the battery cell 1 may not immediately become a stable steady state because of a capacitor component of the battery cell 1. Since the battery cell 1 is a heating element, even if the cell current flowing through the battery cell 1 reaches 0 A, the battery temperature may not immediately reach a stable steady state. Such a state exerts an influence on the change in the terminal voltage used for calculating the internal resistance of the battery cell 1, generating an error in the calculation result of the internal resistance of the battery cell 1.

Therefore, in the present embodiment, the charge amount calculation unit 14 integrates the cell current acquired by the current acquisition unit 12 over time to calculate the amount of charge that has moved to the battery cell 1 on the basis of the case where the battery cell 1 is in the no-load state.

In this way, the storage battery control devices 10 and 800 according to the third embodiment can suppress the influence of the cell current of the battery cell 1 before calculating the internal resistance of the battery cell 1 on the terminal voltage of the battery cell 1, thereby improving the calculation precision of the internal resistance of the battery cell 1.

As described above, even if the input current flowing through the battery system 11 when calculating the internal resistance of the battery cell 1 is not a pulse current, the first to third embodiments allow the internal resistance of the battery cell 1 to be calculated with high precision by using the amount of charge obtained by integrating over time the cell current flowing through the battery cell 1 as an indicator.

Note that a computer program executed by the storage battery control devices 10 and 800 of the present embodiment is provided by being incorporated in advance in a read only memory (ROM) or the like. The computer program executed by the storage battery control devices 10 and 800 of the present embodiment may be a file in an installable format or an executable format, and may be configured to be recorded and provided in a computer-readable recording medium such as a CD-ROM, flexible disk (FD), CD-R, and digital versatile disk (DVD).

Moreover, the computer program executed by the storage battery control devices 10 and 800 of the present embodiment may be configured to be stored in a computer connected to a network such as the Internet and provided by downloading via the network. The computer program executed by the storage battery control devices 10 and 800 of the present embodiment may be configured to be provided or distributed via a network such as the Internet.

The computer program executed by the storage battery control devices 10 and 800 of the present embodiment has a modular configuration including the above-described units (current acquisition unit 12, voltage acquisition unit 13, charge amount calculation unit 14, internal resistance calculation unit 15, temperature acquisition unit 21, internal resistance temperature correction unit 22, display control unit 16). As actual hardware, when a central processing unit (CPU) serving as an example of a processor reads a computer program from the ROM and executes the computer program, each of the units is loaded on a main storage device, and the current acquisition unit 12, the voltage acquisition unit 13, the charge amount calculation unit 14, the internal resistance calculation unit 15, the temperature acquisition unit 21, the internal resistance temperature correction unit 22, and the display control unit 16 are generated on the main storage device.

Some embodiments of the present invention have been described, but these embodiments are presented as examples and are not intended to limit the scope of the invention. These novel embodiments can be implemented in various other forms, and various omissions, replacements, and changes can be made without departing from the gist of the invention. These embodiments and modifications thereof are included in the scope and gist of the invention, and are also included in the scope of the invention described in the claims and equivalents thereof.

## Claims

1. An internal resistance calculation device comprising:
a current acquisition unit configured to acquire a battery current flowing through a battery;
a voltage acquisition unit configured to acquire a battery voltage applied to the battery;
a charge amount calculation unit configured to calculate an amount of charge that has moved to the battery, the amount of charge being calculated by integrating the battery current acquired by the current acquisition unit over time; and
an internal resistance calculation unit configured to calculate internal resistance of the battery on the basis of an amount of variation in the battery current and an amount of variation in the battery voltage, each being obtained until the amount of charge calculated by the charge amount calculation unit becomes equal to or greater than a preset threshold.

2. The internal resistance calculation device according to claim 1, further comprising:
a temperature acquisition unit configured to acquire a temperature of the battery; and
a correction unit configured to correct the internal resistance calculated by the internal resistance calculation unit on the basis of the temperature of the battery acquired by the temperature acquisition unit.

3. The internal resistance calculation device according to claim 1 or 2, wherein the internal resistance calculation unit is configured to discard a calculation result of the internal resistance in a case where elapsed time from when the current starts to flow through the battery until when the amount of charge becomes equal to or greater than the threshold is equal to or longer than a predetermined time.

4. The internal resistance calculation device according to any one of claims 1 to 3, wherein the charge amount calculation unit is configured to calculate the amount of charge on the basis of a case where the battery is in a no-load state.

5. A battery control system comprising:
a battery;
an acquisition unit configured to acquire a battery current flowing through the battery;
a detection unit configured to acquire a battery voltage applied to the battery;
a charge amount calculation unit configured to calculate an amount of charge that has moved to the battery, the amount of charge being calculated by integrating the battery current acquired by the acquisition unit over time; and
an internal resistance calculation unit configured to calculate internal resistance of the battery on the basis of an amount of variation in the battery current and an amount of variation in the battery voltage, each being obtained until the amount of charge calculated by the charge amount calculation unit becomes equal to or greater than a preset threshold.

6. An internal resistance calculation method performed by an internal resistance calculation device, the method comprising:
a step of acquiring a battery current flowing through a battery;
a step of acquiring a battery voltage applied to the battery;
a step of calculating an amount of charge that has moved to the battery, the amount of charge being calculated by integrating the battery current over time; and
a step of calculating internal resistance of the battery on the basis of an amount of variation in the battery current and an amount of variation in the battery voltage, each being obtained until the amount of charge becomes equal to or greater than a preset threshold.
